# EUROPEAN PATENT SPECIFICATION

(11) **EP 0 415 369 B1**
(45) Date of publication and mention of the grant of the patent: **27.12.1995**
(21) Application number: 90116509.2
(22) Date of filing: 28.08.1990
(51) Int. Cl.: G11C 5/02, G11C 8/00

(54) **Semiconductor memory device**
Halbleiterspeicheranordnung
Dispositif de mémoire à semi-conducteurs

(30) Priority: 30.08.1989 JP 223719/89
(43) Date of publication of application: 06.03.1991
(73) Proprietor: NEC CORPORATION, Tokyo (JP)
(72) Inventor: Hayano, Kiminori, c/o NEC Corporation, Tokyo 108-01 (JP)
(74) Representative: Glawe, Delfs, Moll & Partner

(56) References cited:
- EP-A- 0 201 185
- EP-A- 0 213 835
- EP-A- 0 317 666
- IEEE JOURNAL OF SOLID-STATE CIRCUITS. vol. 17, no. 3, June 1982, NEW YORK US pages 459 - 464; ANCEAU ET AL: 'Complex Integrated Circuit Design Strategy'
- WESTE NHE ET AL 'Principles of CMOS VLSI Design' October 1985 , ADDISON-WESLEY , READING, US

## Description

The present invention relates to a semiconductor device and, particularly, to a wiring connection of a semiconductor memory device to a decoder circuit.

In general, a semiconductor memory device includes, on a chip, two regions, one being a first region formed in substantially a center portion of the chip and comprising a circuit block formed by a periodic repetition of patterns of a plurality of memory cells and a plurality of decoder circuit blocks adjacent thereto and the other being a second region arranged outside the first region and in which circuits such as a redundancy circuit and an address generator circuit are formed.

In such a semiconductor memory device as above, address signal lines which are common to the respective decoder circuit blocks are arranged so as to traverse the respective decoder circuit blocks. Among circuits arranged in the second region of the semiconductor memory device, however, circuits such as the redundancy circuit and the address generator circuit which receive and provide address signals must be connected to address signal lines. That is, wirings from these circuits in the second region must be connected to the address lines.

In a conventional memory device, a space existing between these two adjacent memory regions is utilized as a wiring region from the circuits in the second region to the address signal lines. That is, since such space is also present in-between corresponding decoder circuit blocks in a respective memory cell region, signal lines corresponding in number to the address signal lines are arranged in this space for connection to the address signal lines.

Since, however, a location of the space is determined by an arrangement of the memory cell regions, locations of circuits such as the redundancy circuit are restricted thereby, resulting in the freedom of circuit arrangement in the second region being reduced.

Further, the recent tendency towards increased memory capacity of a semiconductor memory device requires a space which is large enough to arrange therein wires corresponding in number to address lines which is increased in number due to the increased memory capacity, resulting in a necessity of increasing chip area.

A semiconductor memory device according to the preamble of claim 1 is disclosed in EP-A-0 213 835. This reference suggests to remove a portion of a decoder circuit block to make room for an extra wiring and placing the removed portion elsewhere on the chip such that the chip area is increased.

It is an object of the invention to provide a semiconductor memory device having a second region thereof in which circuit arrangement can be done freely.

A further object of the invention if to provide a semiconductor memory device which chip area is not increased even if the number of address lines is increased.

These objects are achieved by a semiconductor memory device as defined in claim 1; the dependent claims are related to further developments of the invention.

The above-mentioned objects, features and advantages of this invention will become apparent by reference to the following detailed description of the present invention in conjunction with the accompanying drawings, where:
Fig. 1 shows a general construction of a conventional semiconductor memory device;
Fig. 2 shows a construction of a conventional X decoder circuit and other circuits associated therewith;
Fig. 3 shows constructions of conventional decoder circuits;
Fig. 4 shows a pattern portion of a conventional decoder circuit corresponding to a NAND circuit and an inverter circuit thereof;
Fig. 5 is a cross section taken along a line A-A in Fig. 4;
Fig. 6 shows a first embodiment of a semiconductor memory device according to the present invention;
Fig. 7 shows a pattern of a portion of the decoder circuit of the semiconductor memory device shown in Fig. 6 corresponding to a NAND circuit and an inverter circuit thereof;
Fig. 8 is a cross section taken along a line B-B in Fig. 7;
Fig. 9 shows a second embodiment of the semiconductor memory device according to the present invention;
Fig. 10 shows a third embodiment of the semiconductor memory device according to the present invention; and
Fig. 11 shows a fourth embodiment of the semiconductor memory device according to the present invention.

Before describing embodiments of the present invention, a conventional semiconductor memory device will be described.

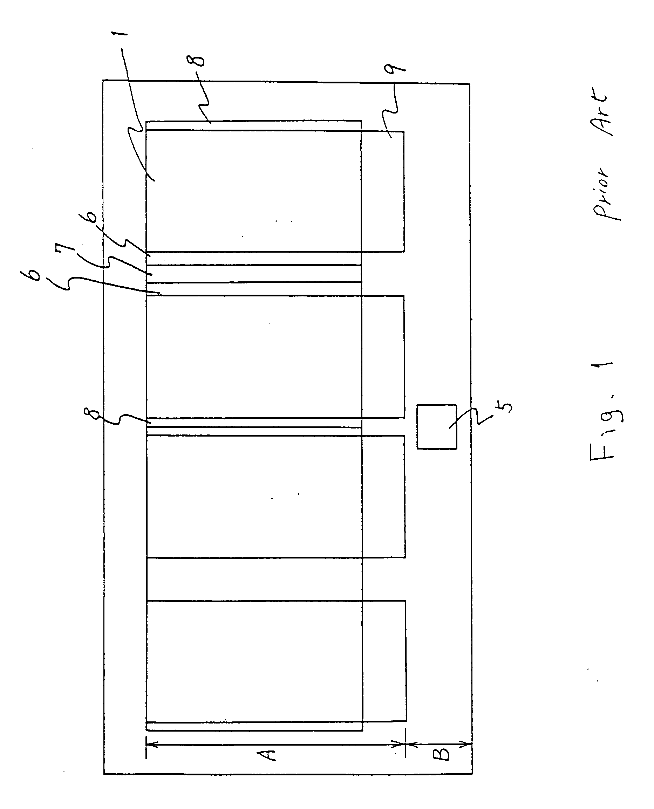

Fig. 1 shows a general construction of a DRAM (dynamic random access memory) of 1M bits. In general, the semiconductor memory device has a first region A arranged substantially in the center of a chip, in which a plurality (in Fig. 1, four) of memory cell arrays 1 are arranged. Adjacent to each of the memory cell arrays 1, circuit blocks are provided each having a regular repetition of patterns of circuits such as an X decoder circuit block 9, a Y decoder circuit block 7, a sense amplifier circuit 6 in which a number of sense amplifiers are formed and data line precharge circuit 8, etc.

On the other hand, in a second region B defined in a peripheral portion of the chip, a control signal generator circuit, a data input/output circuit and electrode pads, etc., all of which are not shown, are formed in addition to a redundancy circuit 5 and an address generator circuit (not shown), etc.

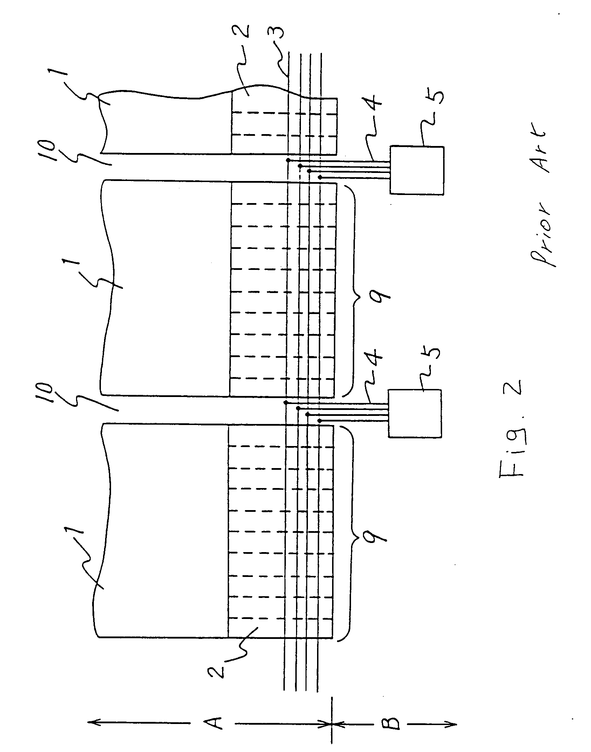

Fig. 2 shows constructions of the X decoder circuit blocks 9 of the semiconductor memory device and other circuits associated therewith. Each X decoder circuit block 9 is constituted with a plurality of decoder circuits 2 having identical constructions and arranged equidistantly. Address signal lines 3 which are common to the respective decoder circuits 2 are formed in an upper aluminum wiring layer traversing the respective decoder circuits 2 of the respective X decoder circuit blocks 9.

Among the circuits arranged in the second region B, such circuits as the redundancy circuit 5 and the address signal generator circuit which are required to receive address signals and output them must be connected to the address signal lines 3. Therefore, wirings 4 extending from each of the redundancy circuits 5 to the address signal lines 3 are provided. The wirings 4 are provided in a high melting point metal layer disposed below the address signal lines 3 and connected thereto. Since, however, there are wirings in the decoders 2, which are formed in the same step as that for forming the wirings 4, it is impossible to arrange the wirings 4 in the decoder circuits 2. Although there is provided a small boundary region between adjacent decoder circuits 2, it does not have a width large enough to accept the wirings 4 therein.

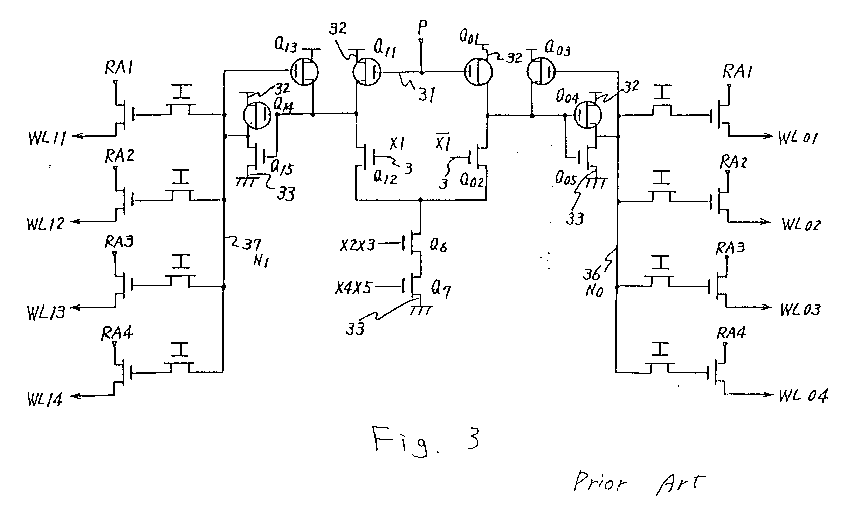

This will be described in more detail with reference to Figs. 3, 4 and 5. Fig. 3 shows a circuit construction of each of the decoder circuits 2 shown in Fig. 2. Address signals X̅1̅ and X1 supplied from the address signal lines 3 are supplied to gates of N channel MOS transistors Q02 and Q12, respectively. Logical product signals X2X3 and X4X5 of address signals produced by circuits not shown are supplied to gates of a pair of series connected N channel MOS transistors Q6 and Q7 having one end connected to GND (ground potential) through an aluminum wire 33, respectively. A precharge signal P supplied from an aluminum wire 31 is supplied to gates of P channel MOS transistors Q01 and Q11 having source supplied with a source voltage Vcc through an aluminum wire 32. A NAND gate is constructed with these transistors.

A pair of outputs of this NAND gate are supplied to respective input portions of an inverter constituted with the series connection of the P channel MOS transistor Q04 having source supplied with the source voltage Vcc from. the aluminum wiring 32 and the N channel MOS transistor Q05 having the source connected to GND through the aluminum wiring 33 and an inverter constituted with similar transistors Q14 and Q15 and outputs N0 and N1 are derived from output lines 36 and 37 thereof, respectively. In response to these outputs N0 and N1, one of word line drive signals RA1 to RA4 appears on one of eight word lines WL01 to WL04 and WL11 to WL14 as a word line drive signal for the memory cell array 1.

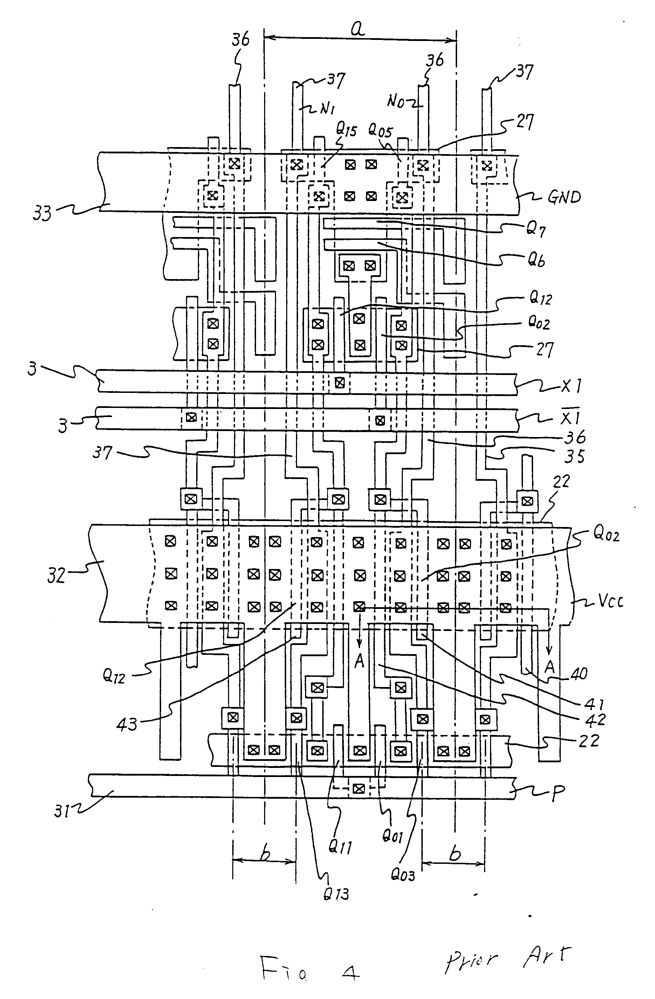

Fig. 4 shows a pattern of a portion of the decoder circuit shown in Fig. 3 corresponding to the NAND circuit and the inverter circuit. In Fig. 4, portions in which the transistors of the circuit in Fig. 3 are formed are depicted by the same reference numerals. Further, wiring layers for signals in Fig. 4 are depicted by the same reference numerals as those used in Fig. 3. There is a region having width a in which a decoder circuit is formed. The value a depends upon the kind of decoder circuit and it is about 28 »m in this example.

In order to form this decoder circuit, signal lines such as the address lines 3, Vcc lines 32, GND lines 33 and precharge lines 31, etc., which are common to the respective decoder circuits are formed by an upper aluminum wiring layer extending over the decoders in the direction traversing them. Below the aluminum wiring layer, polysilicon layer 40 to 43 used as gate electrodes of for instance the P channel MOS transistors Q01 and Q11 and the N channel MOS transistors Q02 and Q12 as well as a high melting point metal wiring used as wirings of the inverter outputs N0 and N1 exist.

Therefore, it is impossible to arrange the wirings 4 provided in the high melting point metal layer within the decoder circuit block 2.

The decoder circuits 2 having identical construction and each arranged in the region having width a shown in Fig. 4 are disposed in the decoder circuity block 9 shown in Fig. 2. Generally, in order to avoid any interference with adjacent circuits, edge portions of the decoder pattern are bounded by regions in which no high melting point metal wiring, etc., is provided. Therefore, there is provided a boundary region b between the adjacent decoder circuits 2. In this example, the value b is about 10 »m. In this pattern construction of decoder circuits, it is difficult to arrange high melting point metal wiring in the region having width b because contact holes may be provided in this region. Therefore, it is impossible to arrange the wiring 4 extending from the redundancy circuit 5 to the address signal lines 3 in the region b between the adjacent decoder circuit blocks 2.

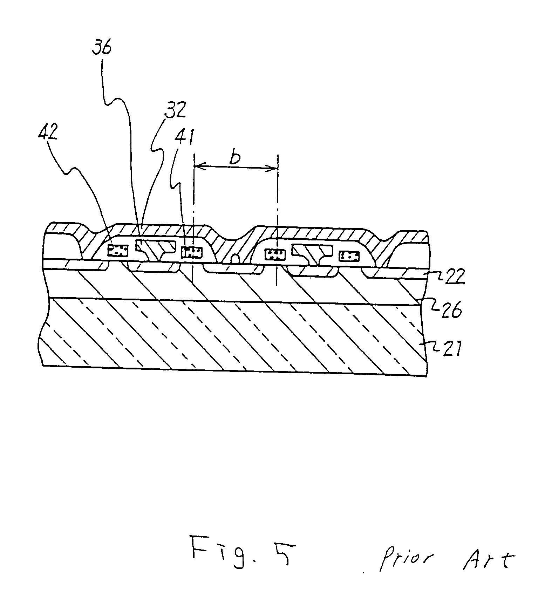

Fig. 5 is a cross section taken along a line A-A in Fig. 4. In the boundary region b, there is no room for other wirings in a region between the aluminum wiring 32 for supplying the source voltage Vcc and an N type impurity region 26, that is, in a layer which is in the same level as that of the high melting point metal wiring 36 as well as the polysilicon layer used as the gate of the transistor Q04.

As mentioned, in the conventional semiconductor memory device, it is impossible to arrange, within the decoder circuit block 9 including the plurality of decoder circuits 2, the wirings 4 interconnecting the address signal lines 3 and the circuits such as the redundancy circuit 5, etc., arranged in the second region B.

Such wiring as the wirings 4 connecting the address signal lines 3 to the redundancy circuit 5 have been arranged in a space 10 between adjacent decoder circuit blocks 9, as shown in Fig. 2. The space 10 is provided due to the fact that, since, as mentioned previously, the Y decoder circuit block and the sense amplifier circuit block and the sense amplifier circuit block are provided between the respective memory cell arrays 1, there is provided a space between the X decoder circuit blocks 9 provided correspondingly to the respective memory cell arrays 1.

Since, however, the region in which the wirings 4 from the address signal lines 3 to where the redundancy circuit 5 is disposed is determined by a location of the space between the decoder circuit blocks 9 in the conventional semiconductor memory device, the redundancy circuit, etc., should be arranged near the space when resistance, etc., of the wiring is considered. That is, the freedom of arrangement of the circuits in this second region B is restricted.

Furthermore, since the number of address lines is increased recently due to the increased capacity of the semiconductor memory device, the space necessary to arrange the wirings 4 corresponding in number to all address lines must be large, resulting in an increased chip area.

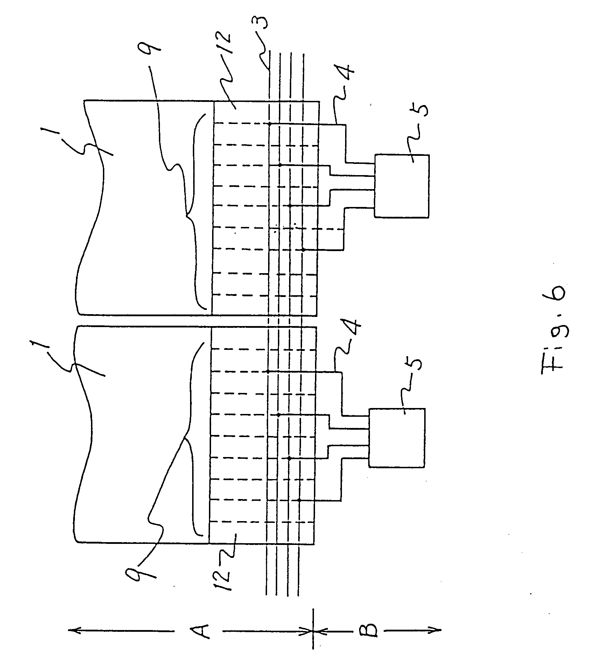

An embodiment of the present invention will be described with reference to Figs. 6 to 11.

Fig. 6 shows the construction of an X decoder circuit blocks 9 of a semiconductor memory device according to a first embodiment of the present invention and its peripheral portion. In this embodiment, an arrangement of wirings 4 connecting address signal lines and a redundancy circuit will be described.

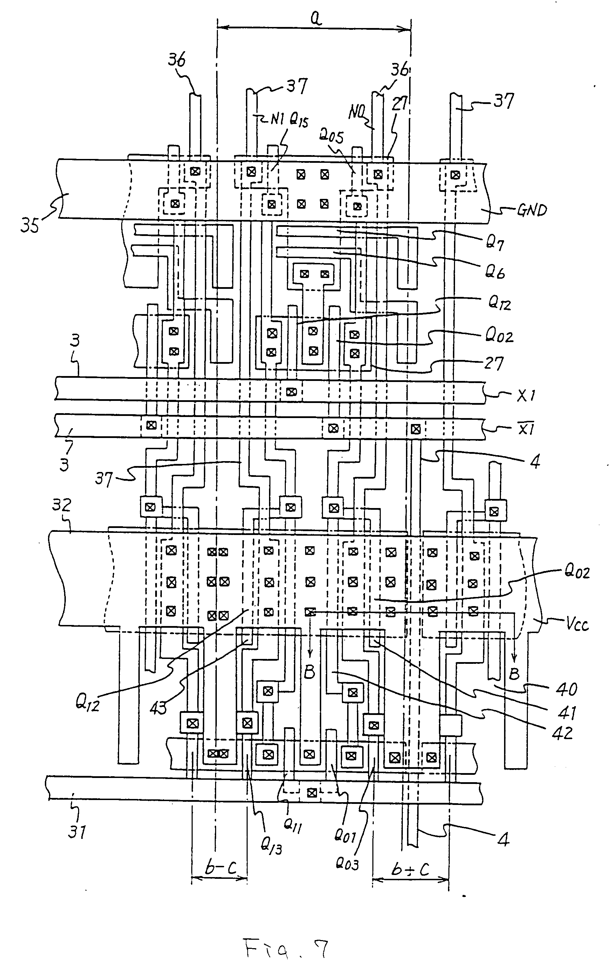

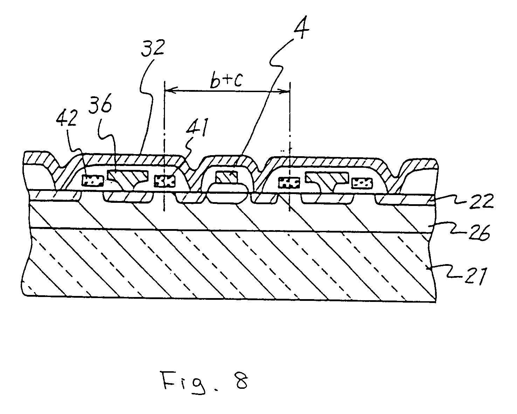

The X decoder circuit block 9 is constituted with a plurality of decoder circuits 12. Each of the decoder circuits 12 has an identical construction to that of the decoder circuit 2 in Fig. 3. The address signal lines 3 are formed in an upper aluminum layer and extend over the respective decoder circuits 12 in directions traversing them. In this embodiment, the wirings 4 connecting the address signal lines 3 and the redundancy circuit 5 are arranged in a boundary region between adjacent ones of the decoder circuits 12. In order to obtain a width of the boundary region large enough to receive the wiring 4, a portion of the region occupied by a predetermined decoder circuit 12 is shifted. This will be described in more detail with reference to Figs. 7 and 8.

Fig. 7 shows a pattern construction of one of the decoder circuits 12 which is adjacent to the boundary region in which a wiring 4 is arranged. In this figure, corresponding portions to those shown in Fig. 4 are depicted by same reference numerals, respectively.

A region in which one decoder circuit is formed exists in a width a in Fig. 7.- In this example, the decoder has an identical circuit construction to the circuit shown in Fig. 3 and a circuit pattern which is basically the same as that shown in Fig. 4.

As mentioned previously, there is the empty region in the side edge portions of the decoder circuit pattern, in which no high melting point metal wiring is provided to avoid the undesired effect on the adjacent circuits. The inventors of this application have found that there is substantially no problem even if this empty region becomes somewhat narrower, since the width of this empty region is designed with considerable tolerance. In this embodiment, the decoder circuit at a center is shifted leftwardly by a distance c without changing its pattern such that the empty regions of the center decoder circuit and another adjacent decoder circuit disposed in a left side of the center decoder are partially overlapped, as shown in Fig. 7. With this leftward shift of the center decoder circuit, the width of a boundary region between these two decoder circuits becomes b-c. In this example, it has been found that the value c of about 3 »m provides no problem.

With such leftward shift of the center decoder circuit by c, the width of the boundary region between the center and the right side decoders becomes b+c, i.e., about 13 »m.

With the increase of boundary region width by c, it becomes possible to arrange in this boundary region the high melting point metal wirings 4 in a lower level than the aluminum wirings 31 and 32. As a result, one wiring 4 supplying an address signal X1 from the address signal line 3 to the redundancy circuit 5 is arranged in this boundary region.

Fig. 8 is a cross section taken along a line B-B in Fig. 7. With the width of the boundary region being b+c, it becomes possible to arrange one wiring 4 in a level between the aluminum wiring 32 for supplying the source voltage Vcc and the N type impurity region 26, through the same step as that of forming the high melting point metal wiring 36.

Returning to Fig. 6, this embodiment will be described in more detail.

As mentioned it is possible to arrange the wiring 4 in the widened boundary region provided by shifting a portion of a predetermined decoder circuit 12. Thus, by shifting decoder circuits arbitrarily selected from the plurality of decoder circuits 12 included in the decoder circuit block 9, it is possible to provide a plurality of boundary regions in each of which the wiring 4 can be arranged. That is, it is possible to arrange the wirings 4 corresponding in number to the address signal lines 3 in arbitrary positions within the decoder circuit block 9. Therefore, the position of the redundancy circuit 5 in the second region B can be freely determined. As a result, the freedom of positional selection of the redundancy circuit and the electrode pads in the second region B is increased since it is possible to determine positions of the redundancy circuit and the electrode pads in the second region B without interfering with each other.

Further, the wirings 4 corresponding in number to the address signal lines can be arranged in the decoder circuit block 9 even when the number of the address signal lines is increased with the increase in the capacity of the semiconductor memory device, and, therefore, the wirings 4 are not required to be located in a limited area. Since, therefore, there is no need to make the space between the adjacent decoder circuit blocks 9 larger as required in the conventional device, an increase in chip area can be avoided.

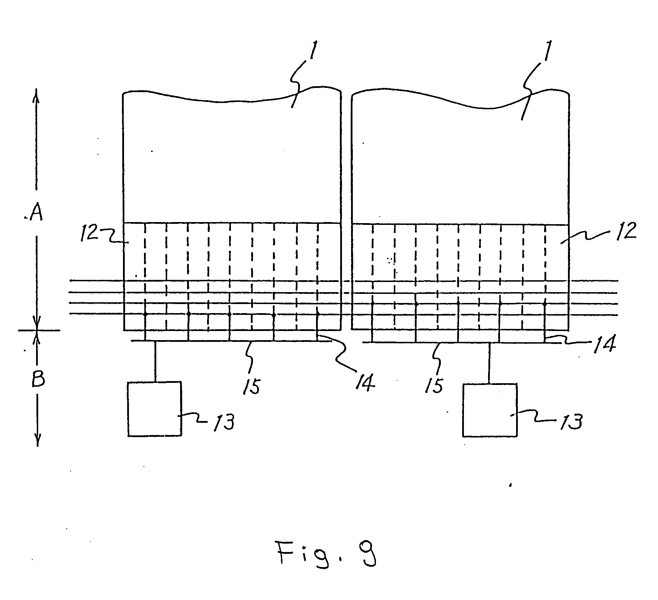

As mentioned previously, among the circuits arranged in the second region B, the address signal generator circuit should be also connected to the address signal lines 3. Another embodiment of the present invention will be described with reference to Fig. 9 as a second embodiment, in which wirings 14 for connecting the address signal lines 3 to the address generator circuit 13 are arranged.

An X decoder circuit block 9 is constituted with a plurality of decoder circuits 12. Each decoder circuit has an identical construction to that of the decoder circuit 12 mentioned in the first embodiment. The address signal lines 3 are provided by an aluminum wiring extending over the respective decoder circuits 12 in a direction traversing them. In order to supply an address signal from the address generator circuit 13 to one of the address signal lines 3, a plurality of parallel wirings 4 are arranged between the address signal lines 3 and an aluminum wiring 15 connected to the address generator circuit. The respective wirings 4 are arranged in a plurality of boundary regions existing between adjacent ones of the decoder circuits 12.

The enlargement of width of the boundary region for arrangement of the wiring 4 can be achieved in the same way as in the first embodiment and the pattern construction of the decoder circuit 12 to be shifted by a distance c is also the same as that of the first embodiment. Therefore, details thereof are omitted.

Only the reason why the plurality of parallel wirings 4 are arranged between the address signal lines 3 and the aluminum wiring 15 and the effect obtainable thereby will be described here. That is, when it is desired to arrange a number of wirings in a narrow region such as the space 10 existing between the adjacent decoder circuit blocks 9, the width of each wiring must be reduced, which causes the resistance value of the wiring to be increased considerably, resulting in delay of address signal transmission. In this embodiment, however, there is substantially no delay of address signal transmission since the resistance of the wiring is reduced due to the parallel connection of the plural wirings 4, even if each wiring 4 has a large resistance value.

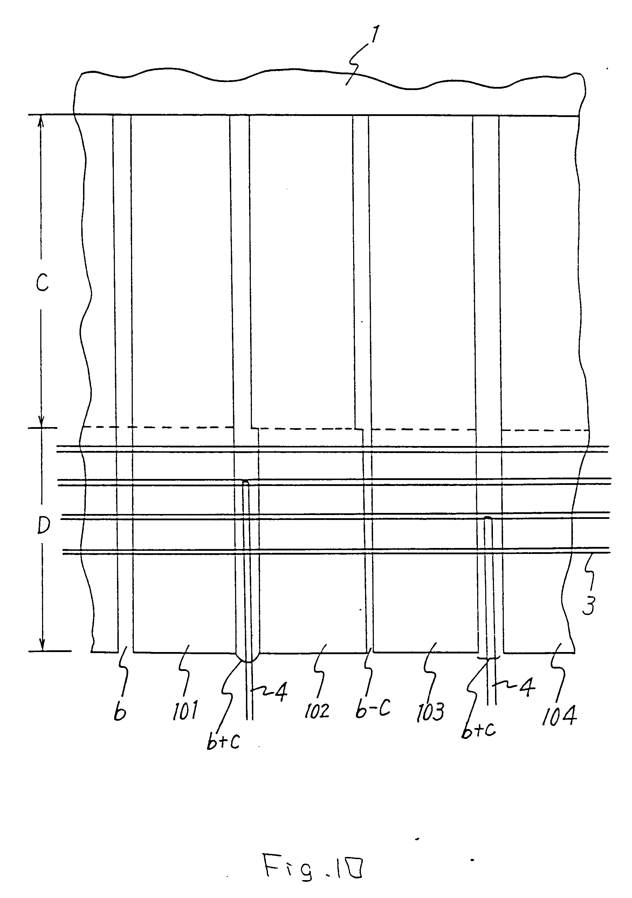

Now, which portion of the decoder circuit is to be shifted will be described. In the first and second embodiments, the shift of the decoder circuit has been described only for the pattern construction portion (Figs. 4 and 7) of the portion corresponding to the NAND circuit and the inverter circuit among the decoder 2 or 12. However, in the present invention, it is possible to shift a portion of the portion constituting one decoder circuit or a whole decoder circuit to expand the boundary region. This will be described with reference to Fig. 10.

For the case where the boundary region is to be expanded by shifting a portion of a decoder circuit, a region D of a decoder circuit 102 is shifted rightwardly by a distance c. Thus, the width of the boundary region becomes b+c making an arrangement of the wiring 4 therein possible. The region D is not always the portion corresponding to the NAND circuit and the inverter circuit shown in Fig. 4 or 7. That is, it is enough for the wider boundary region that it exists in an area between a cross point of the address signal line 3 and the wiring 4 and the redundancy circuit. In the case shown in Fig. 10, a region D of the decoder circuit 102 is stepped by c with respect to a region C thereof. Therefore, the wiring pattern of this stepped portion is modified by adding a lateral wiring to each of the internal wirings which are disconnected by this shift.

Now, an example where a whole decoder circuit is shifted to expand the boundary region will be described. By shifting a whole decoder circuit 104 rightwardly by c, the width of the boundary region between decoders 103 and 102 becomes b+c, so that it is possible to arrange a wiring 4 in this region. According to this example, it is possible to expand the boundary region without modifying the internal wiring pattern of the decoder circuit .

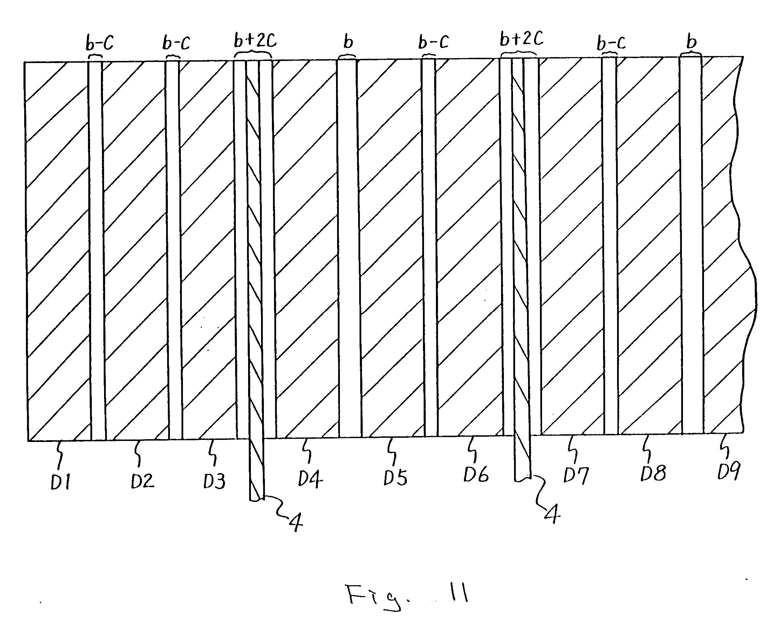

Although, in the above-mentioned example in which one decoder circuit is shifted by c to make the width of the boundary region b+c, there may be a case where it is impossible to arrange a wiring 4 within the region b+c, depending upon values of b and c and/or the kind of wiring. Further, there may be a case where a plurality of wirings 4 should be arranged within the boundary region. In order to solve these problems, the width of the boundary region should be expanded further. Fig. 11 shows another embodiment of the present invention by which such further expansion of the boundary region is realized.

When the width of the boundary region is to be made b+2c, a decoder circuit D2 is shifted first leftwardly by c to make the width of a boundary region between decoder circuits D1 and D2 b-c and a decoder circuit D3 is also shifted leftwardly by c to make the width of a boundary region between the decoder circuits D2 and D3 b-c. Therefore, the width of a boundary region between the decoder circuits D3 and D4 becomes b+2c. That is, by shifting a plurality of decoder circuits in the same direction, a boundary region having any desired width can be provided.

Alternatively, a decoder circuit D6 is shifted leftwardly by c to make the width of boundary region between a decoder circuit D5 and the decoder circuit D6 b-c and a decoder circuit D7 is shifted rightwardly by c to make the width of boundary region between the decoder circuit D7 and a decoder circuit D8 b-c. Therefore, the width of boundary region between the decoder circuits D6 and D7 becomes b+2c.

That is, such further expansion of the boundary region can be realized by shifting a plurality of decoder circuits in the same direction or shifting adjacent decoder circuits the width of boundary region between which it is to be expanded in opposite directions.

Although, in either example mentioned above, the width of the boundary region is made b+2c by moving two decoder circuits, any width expansion a boundary region between adjacent decoder circuits can be done by increasing the number of decoder circuits to be shifted. In a case where a plurality of decoder circuits are shifted, the shifting amount of each decoder circuit is not limited to c. That is, these decoder circuits can be shifted by any desired distances, respectively.

Although the present invention has been described with respect to a DRAM as the memory cell array 1, the present invention is not limited thereto and equally applicable to any memory such as static RAM (SRAM). Although, in such case, the kind of decoder depends upon the kind of memory, the present invention can be used for any decoder circuit. Therefore, the decoder circuit shown in Fig. 3 and the pattern constructions shown in Figs. 4 and 7 are mere examples.

Further, although the present invention has been described with reference to the X decoder circuit block 9, the present invention is equally applicable to the Y decoder circuit block 7.

Further, it should be noted that the signal lines connected to the second region B are not always the address signal lines 3. That is, these signal lines may be any lines provided that they must be connected to the circuit in the second region B. For example, they may be signal lines for a control signal, such as precharge signal, of a decoder circuit.

The circuits existing in the second region B and connected by the wirings 4 are not limited to the redundancy circuit and address generator circuit. For example, it may be a control signal generator circuit for the decoder.

Although the wiring 4 has been described as having high melting point metal, any of aluminum, silicide and polycrystal silicon may be used therefor.

Further, although the wiring 4 is single layered in Fig. 8, it is possible to make it multilayered so that the number of wirings in the expanded boundary region can be increased.

## Claims

1. A semiconductor memory device comprising at least one memory cell array (1), a decpder circuit block (9) corresponding to said memory cell array and including a plurality of decoder circuits (2), each decoder circuit (2) being separated from its immediately adjacent decoder circuit by a boundary region (b) to avoid circuit interference, charaterized in that said boundary regions (b) include a wide-width boundary region (b+c, b+2c...) for wiring, a normal-width boundary region (b) and a narrow-width boundary region (b-c), said wide width boundary region being formed by shifting a desired portion of at least one of said decoder circuits (2) by a desired distance (c) so that at least one narrow-width boundary region (b-c) is also formed, and in that a wiring (4) is arranged in said wide-width boundary region (b+c, b+2c...).

2. The semiconductor memory device claimed in claim 1, wherein said wiring (4) in said wide-width boundary region connects signal lines in said decoder circuit (2) to circuits provided outside said decoder circuit.

3. The semiconductor memory device claimed in claim 2, wherein a plurality of said wide-width boundary regions is provided in said decoder circuit block (9) and a plurality of said wirings (4) is arranged within said wide-width boundary regions.

4. The semiconductor memory device claimed in claim 3, wherein said wiring (4) in said decoder circuit block (9) is connected to address signal lines (3).

5. The semiconductor memory device claimed in claim 4, wherein said plurality of said wirings (4) corresponds in number to said address signal lines (3) in said decoder circuit and said respective wirings in said wide-width boundary regions are connected to corresponding said address signal lines.

6. The semiconductor memory device claimed in claim 4, wherein said plurality of said wiring (4) in said wide-width boundary regions are connected in parallel to one of said address signal lines in said decoder circuit block (9).

7. The semiconductor memory device claimed in claim 1, wherein a plurality of said decoder circuits (2) is shifted by said desired distance.

8. The semiconductor memory device claimed in claim 1, wherein said desired portion of said decoder circuit shifted by said desired distance is the whole of said decoder circuit.

9. The semiconductor memory device claimed in claim 2, wherein said desired portion of said decoder circuit shifted by said desired distance is a region (D) thereof including said wiring in said decoder circuit.

10. The semiconductor memory device claimed in claim 2, wherein said circuits provided outside of said decoder circuit include a redundancy circuit (5).

11. The semiconductor memory device claimed in claim 2, wherein said circuits provided outside of said decoder circuit include an address generator circuit.

12. The semiconductor memory device claimed in claim 2, wherein said circuits provided outside of said decoder circuit include a control signal generator circuit for said decoder circuit.

13. The semiconductor memory device claimed in claim 1, wherein said memory cell is a DRAM.

14. The semiconductor memory device claimed in claim 1, wherein said memory cell is an SRAM.

15. The semiconductor memory device claimed in claim 1, wherein said decoder circuit (2) is an X decoder.

16. The semiconductor memory device claimed in claim 1, wherein said decoder circuit (2) is a Y decoder.

17. The semiconductor memory device claimed in claim 1, wherein said wiring (4) is a multi-layered wiring.

18. A semiconductor memory device claimed in claim 1 wherein said at least one memory cell array is formed on a semiconductor substrate, and said semiconductor memory device further comprises a plurality of address signal lines (3) extending over said decoder circuits (2) in a direction traversing them, said decoder circuits being constituted with circuit elements arranged in identical patterns and interconnected by a lower wiring layer (36) arranged below said address signal lines (3), a peripheral circuit (5) arranged outside (B) said decoder circuit block (9), said address signal lines (3) being formed in an upper wiring layer wherein said wiring (4) connects said address signal lines (3) to said peripheral circuit (5) via a level lower than said address signal lines (3).

## Patentansprüche

1. Halbleiterspeichervorrichtung mit mindestens einem Speicherzellenfeld (1), einem Decoderschaltungsblock (9), der dem Speicherzellenfeld entspricht und eine Anzahl von Decoderschaltungen (2) aufweist, wobei jede Decoderschaltung (2) von ihrer direkt benachbarten Decoderschaltung durch einen Grenzbereich (b) getrennt ist, um Schaltungsinterferenzen zu vermeiden, dadurch gekennzeichnet, daß die Grenzbereiche (b) einen breiten Grenzbereich (b+c, b+2c...) zur Verdrahtung umfassen, einen normal breiten Grenzbereich (b) und einen schmalen Grenzbereich (b-c), wobei der breite Grenzbereich durch Verschieben eines gewünschten Abschnitts zumindest einer der Decoderschaltungen (2) um einen gewünschten Abstand (c) gebildet wird, so daß zumindest auch ein schmaler Grenzbereich gebildet wird, und daß eine Verdrahtung (4) in dem breiten Grenzbereich (b+c, b+2c...) angeordnet ist.

2. Halbleiterspeichervorrichtung nach Anspruch 1, wobei die Verdrahtung in dem breiten Grenzbereich Signalleitungen in der Decoderschaltung (2) mit Schaltungen verbindet, die außerhalb der Decoderschaltung angeordnet sind.

3. Halbleiterspeichervorrichtung nach Anspruch 2, wobei eine Anzahl von breiten Grenzbereichen in dem Decoderschaltungsblock (9) vorgesehen ist und wobei eine Anzahl der Verdrahtungen (4) innerhalb der breiten Grenzbereiche angeordnet ist.

4. Halbleiterspeichervorrichtung nach Anspruch 3, wobei die Verdrahtung (4) in dem Decoderschaltungsblock (9) mit Adreßsignalleitungen (3) verbunden ist.

5. Halbleiterspeichervorrichtung nach Anspruch 4, wobei die Anzahl der Verdrahtungen (4) hinsichtlich der Zahl den Adreßsignalleitungen (3) in der Decoderschaltung entspricht und wobei entsprechende Verdrahtungen in den breiten Grenzbereichen mit entsprechenden Adreßsignalleitungen verbunden sind.

6. Halbleiterspeichervorrichtung nach Anspruch 4, wobei die Anzahl der Verdrahtungen (4) in den breiten Grenzbereichen parallel mit einer der Adreßsignalleitungen in dem Decoderschaltungsblock (9) verbunden sind.

7. Halbleiterspeichervorrichtung nach Anspruch 1, wobei eine Anzahl der Decoderschaltungen (2) um den gewünschten Abstand verschoben ist.

8. Halbleiterspeichervorrichtung nach Anspruch 1, wobei der gewünschte Abschnitt der Decoderschaltung, der um den gewünschten Abstand verschoben ist, die ganze Decoderschaltung ist.

9. Halbleiterspeichervorrichtung nach Anspruch 2, wobei der gewünschte Abschnitt der Decoderschaltung, der um den gewünschten Abstand verschoben wird, ein Bereich (D) ist, der die Verdrahtung in der Decoderschaltung umfaßt.

10. Halbleiterspeichervorrichtung nach Anspruch 2, wobei die außerhalb der Decoderschaltung vorgesehenen Schaltungen eine Redundanzschaltung (5) umfassen.

11. Halbleiterspeichervorrichtung nach Anspruch 2, wobei die außerhalb der Decoderschaltung vorgesehenen Schaltungen eine Adreßgeneratorschaltung aufweisen.

12. Halbleiterspeichervorrichtung nach Anspruch 2, wobei die außerhalb der Decoderschaltung vorgesehenen Schaltungen eine Steuersignalgeneratorschaltung für die Decoderschaltung aufweisen.

13. Halbleiterspeichervorrichtung nach Anspruch 1, wobei die Speicherzelle ein DRAM ist.

14. Halbleiterspeichervorrichtung nach Anspruch 1, wobei die Speicherzelle eine SRAM ist.

15. Halbleiterspeichervorrichtung nach Anspruch 1, wobei die Decoderschaltung (2) ein X-Decoder ist.

16. Halbleiterspeichervorrichtung nach Anspruch 1, wobei die Decoderschaltung (2) ein Y-Decoder ist.

17. Halbleiterspeichervorrichtung nach Anspruch 1, wobei die Verdrahtung (4) eine Mehrschichtverdrahtung ist.

18. Halbleiterspeichervorrichtung nach Anspruch 1, wobei das zumindest eine Speicherzellenfeld auf einem Halbleitersubstrat gebildet ist und wobei die Halbleiterspeichervorrichtung weiterhin aufweist eine Anzahl von Adreßsignalleitungen (3), die sich über die Decoderschaltungen (2) in einer Querrichtung zu ihnen erstrecken, wobei die Decoderschaltungen aus Schaltungselementen aufgebaut sind, die in identischen Mustern angeordnet sind und durch eine untere Verdrahtungsschicht (36), die unterhalb der Adreßsignalleitungen (3) angeordnet ist, verbunden sind, wobei eine Peripherieschaltung (5) außerhalb (B) des Decoderschaltungsblocks (9) angeordnet ist, die Adreßsignalleitungen (3) in einer oberen Verdrahtungsschicht ausgebildet sind und die Verdrahtung (4) die Adreßsignalleitungen (3) mit der Peripherieschaltung (5) über einen Pegel verbindet, der tiefer ist als die Adreßsignalleitungen (3).

## Revendications

1. Dispositif de mémoire à semi-conducteurs comprenant au moins un tableau (1) de cellules de mémoire, un bloc (9) de circuits de décodage correspondant audit tableau de cellules de mémoire et comportant une pluralité de circuits de décodage (2), chaque circuit de décodage (2) étant séparé de son circuit de décodage immédiatement adjacent par une région limite (b) pour éviter une interférence des circuits, caractérisé en ce que lesdites régions limites (b) comportent une région limite de grande largeur (b+c, b+2c, ...) pour le câblage, une région limite de largeur normale (b) et une région limite de faible largeur (b-c), ladite région limite de grande largeur étant formée en décalant une partie souhaitée d'au moins l'un desdits circuits de décodage (2) d'une distance (c) souhaitée de telle sorte qu'au moins une région limite de faible largeur (b-c) soit aussi formée, et en ce qu'un câblage (4) est disposé dans ladite région limite de grande largeur (b+c, b+2c, ...).

2. Dispositif de mémoire à semi-conducteurs selon la revendication 1, dans lequel ledit câblage (4) dans ladite région limite de grande largeur connecte des lignes de signal dans ledit circuit de décodage (2) à des circuits fournis à l'extérieur dudit circuit de décodage.

3. Dispositif de mémoire à semi-conducteurs selon la revendication 2, dans lequel une pluralité desdites régions limites de grande largeur est fournie dans ledit bloc (9) de circuits de décodage et une pluralité desdits câblages (4) est disposée dans lesdites régions limites de grande largeur.

4. Dispositif de mémoire à semi-conducteurs selon la revendication 3, dans lequel ledit câblage (4) dans ledit bloc (9) de circuits de décodage est connecté à des lignes (3) de signal d'adresse.

5. Dispositif de mémoire à semi-conducteurs selon la revendication 4, dans lequel ladite pluralité desdits câblages (4) correspond en nombre auxdites lignes (3) de signal d'adresse dans ledit circuit de décodage et lesdits câblages respectifs dans lesdites régions limites de grande largeur sont connectés auxdites lignes de signal d'adresse correspondantes.

6. Dispositif de mémoire à semi-conducteurs selon la revendication 4, dans lequel ladite pluralité desdits câblages (4) dans lesdites régions limites de grande largeur est connectée en parallèle à l'une desdites lignes de signal d'adresse dans ledit bloc (9) de circuits de décodage.

7. Dispositif de mémoire à semi-conducteurs selon la revendication 1, dans lequel une pluralité desdits circuits de décodage (2) est décalée de ladite distance souhaitée.

8. Dispositif de mémoire à semi-conducteurs selon la revendication 1, dans lequel ladite partie souhaitée dudit circuit de décodage décalée de ladite distance souhaitée est la totalité dudit circuit de décodage.

9. Dispositif de mémoire à semi-conducteurs selon la revendication 2, dans lequel ladite partie souhaitée dudit circuit de décodage décalée de ladite distance souhaitée est une région (D) de celui-ci comportant ledit câblage dans ledit circuit de décodage.

10. Dispositif de mémoire à semi-conducteurs selon la revendication 2, dans lequel lesdits circuits fournis à l'extérieur dudit circuit de décodage comportent un circuit de redondance (5).

11. Dispositif de mémoire à semi-conducteurs selon la revendication 2, dans lequel lesdits circuits fournis à l'extérieur dudit circuit de décodage comportent un circuit générateur d'adresses.

12. Dispositif de mémoire à semi-conducteurs selon la revendication 2, dans lequel lesdits circuits fournis à l'extérieur dudit circuit de décodage comportent un circuit générateur de signaux de commande pour ledit circuit de décodage.

13. Dispositif de mémoire à semi-conducteurs selon la revendication 1, dans lequel ladite cellule de mémoire est une DRAM.

14. Dispositif de mémoire à semi-conducteurs selon la revendication 1, dans lequel ladite cellule de mémoire est une SRAM.

15. Dispositif de mémoire à semi-conducteurs selon la revendication 1, dans lequel ledit circuit de décodage (2) est un décodeur horizontal.

16. Dispositif de mémoire à semi-conducteurs selon la revendication 1, dans lequel ledit circuit de décodage (2) est un décodeur vertical.

17. Dispositif de mémoire à semi-conducteurs selon la revendication 1, dans lequel ledit câblage (4) est un câblage multicouche.

18. Dispositif de mémoire à semi-conducteurs selon la revendication 1, dans lequel ledit au moins un tableau de cellules de mémoire est formé sur un substrat semiconducteur, et ledit dispositif de mémoire à semiconducteurs comprend en outre une pluralité de lignes (3) de signal d'adresse s'étendant au-dessus desdits circuits de décodage (2) dans une direction les traversant, lesdits circuits de décodage étant constitués par des éléments de circuits disposés dans des impressions identiques et interconnectés par une couche inférieure de câblage (36) disposée au-dessous desdites lignes (3) de signal d'adresse, un circuit périphérique (5) disposé à l'extérieur (B) dudit bloc (9) de circuits de décodage, lesdites lignes (3) de signal d'adresse étant formées dans une couche supérieure de câblage, dans lequel ledit câblage (4) connecte lesdites lignes (3) de signal d'adresse audit circuit périphérique (5) via un niveau inférieur à celui desdites lignes (3) de signal d'adresse.
